# EUROPÄISCHE PATENTSCHRIFT

(11) **EP 2 577 861 B1**
(45) Veröffentlichungstag und Bekanntmachung des Hinweises auf die Patenterteilung: **19.10.2016**
(21) Anmeldenummer: 11717280.9
(22) Anmeldetag: 04.05.2011
(51) Int. Cl.: H02P 6/14, B62D 5/04, B62D 15/02, B82Y 25/00, G01R 33/09

(54) **ELEKTROMOTOR, LENKVORRICHTUNG UND VERFAHREN**
ELECTRIC MOTOR, STEERING DEVICE AND METHOD
MOTEUR ÉLECTRIQUE, DISPOSITIF DE DIRECTION ET PROCÉDÉ

(30) Priorität: 27.05.2010 DE 102010029332
(43) Veröffentlichungstag der Anmeldung: 10.04.2013
(73) Patentinhaber: Robert Bosch GmbH, 70442 Stuttgart (DE)
(72) Erfinder: CHABAUD, Antoine, 71732 Tamm (DE); HIRY, Pascal, 71665 Vaihingen / Enz (DE)
(86) Internationale Anmeldenummer: PCT/EP2011/057129
(87) Internationale Veröffentlichungsnummer: WO 2011/147664

(56) Entgegenhaltungen:
- EP-A1- 1 923 299
- FR-A1- 2 806 853
- US-A- 6 122 579
- US-A1- 2004 015 307

## Beschreibung

### Stand der Technik

Die Erfindung betrifft einen elektronisch kommutierten Elektromotor. Der elektronisch kommutierte Elektromotor weist einen Stator und einen insbesondere permanentmagnetisch ausgebildeten Rotor auf. Der Elektromotor weist auch einen Rotorpositionssensor auf, wobei der Rotorpositionssensor ausgebildet ist, eine vorbestimmte Anzahl von insbesondere diskreten Rotorpositionen entlang einer Rotorumlaufrichtung des Rotors zu erfassen.

Der Rotorpositionssensor ist auch ausgebildet, ein die Rotorpositionen repräsentierendes Sensorsignal zu erzeugen. Der Elektromotor weist auch eine mit dem Rotorpositionssensor verbundene Steuereinheit auf, wobei die Steuereinheit ausgebildet ist, den Stator zum Erzeugen eines magnetischen Drehfeldes in Abhängigkeit des Sensorsignals anzusteuern.

Bei aus dem Stand der Technik bekannten elektronisch kommutierten Elektromotoren, beispielsweise bei Elektromotoren, welche zum Erzeugen eines unterstützenden Lenkmoments bei einer Servolenkung eingesetzt sind, wird zum Steuern des Drehmoments und zum Erzeugen der Drehbewegung des Rotors die Rotorposition mittels wenigstens eines Rotorpositionssensors, beispielsweise mittels eines Hall-Sensors, eines AMR-Sensors (AMR = Anisotrope-Magneto-Resistive) oder eines GMR-Sensors (GMR = Giant-Magneto-Resistive) erfasst. Als Beispiele seien die Dokumente US 6122579 und EP1923299 genannt.

Die Zahl der mittels solcher Rotorpositionssensoren erfassbarer Rotorpositionen hängt beispielsweise bei Einsatz von Hall-Sensoren von der Zahl der Rotorpositionssensoren und/oder von einer Polzahl eines Gebermagnets ab, welche mit dem Elektromotor als Bestandteil des Elektromotors verbunden sind.

### Offenbarung der Erfindung

Die Erfindung wird durch die Merkmale des Vorrichtungsanspurchs 1 und des Verfahrensanspruchs 11 definiert. Die abhängigen Ansprüche definieren vorteilhafte Ausgestaltungen der Erfindung.

Erfindungsgemäß weist die Steuereinheit einen Eingang für einen Lenkwinkel einer Fahrzeuglenkung repräsentierendes, insbesondere analoges oder digitales Lenkwinkelsignal auf. Die Steuereinheit ist ausgebildet, den Stator zusätzlich in Abhängigkeit des Lenkwinkelsignals anzusteuern. Durch das zusätzliche Ansteuern des Rotors in Abhängigkeit des Lenkwinkelsignals kann die Steuereinheit vorteilhaft wenigstens einen weiteren Parameter, nämlich das Lenkwinkelsignal zum Erzeugen des magnetischen Drehfelds heranziehen.

Der Elektromotor ist beispielsweise eine Synchronmaschine oder eine Asynchronmaschine.

Die Steuereinheit ist beispielsweise durch einen Mikroprozessor, einem Mikrocontroller oder ein FPGA (FPGA = Field-Programmable-Gate-Array) gebildet.

In einer bevorzugten Ausführungsform ist die Steuereinheit ausgebildet, wenigstens eine Rotorposition des Rotors in Abhängigkeit des Lenkwinkelsignals zu ermitteln. Die Steuereinheit kann dazu beispielsweise wenigstens eine Recheneinheit und einen mit der Recheneinheit verbundenen Zeitgeber aufweisen. Die Steuereinheit ist weiter bevorzugt ausgebildet, wenigstens eine Rotorposition gemäß einem vorbestimmten Untersetzungsverhältnis zu ermitteln.

So entsprechen beispielsweise zehn Rotorumdrehungen des Elektromotors einer Drehung von fünf Grad eines Fahrzeuglenkrades. Lenkwinkelsensoren werden vorteilhaft bei Fahrzeugen zum Liefern eines Eingangsparameters eines ESP-Systems eingesetzt. Dadurch kann vorteilhaft eine Auflösung einer Rotorpositionserfassung im Vergleich zu einem bloßen Einsatz eines Rotorpositionssensors erhöht sein. Weiter vorteilhaft kann ein Erfassungswinkelbereich einer Rotorpositionserfassung entlang eines Rotorumlaufes im Vergleich zu einem bloßen Ansteuern in Abhängigkeit des Sensorsignals des Rotorpositionssensors erhöht sein.

Dazu können so bei Fahrzeugen, welche mit einem Lenkwinkelsensor ausgerüstet sind, von der Steuereinheit weitere Rotorpositionen in Abhängigkeit ermittelt werden, zusätzlich zu den Rotorpositionen, welche von dem Rotorpositionssensor erfasst worden sind. Zur Ansteuerung des Elektromotors steht so ein Rotorpositionssignal mit hoher Auflösung aufwandsgünstig zur Verfügung, da weitere Rotorpositionssensoren nicht eingesetzt werden müssen um eine Winkelauflösung des Rotorpositionssignals zu erhöhen.

Der Rotorpositionssensor ist beispielsweise ausgebildet, zwei, drei oder bis zu vier Rotorpositionen entlang eines Rotorumlaufes des Rotors zu erfassen.

Mittels der so ausgebildeten Steuereinheit können vorteilhaft zusätzlich zu den zwei, drei oder bis zu vier Rotorpositionen entlang des Rotorumlaufes weitere Rotorpositionen in Abhängigkeit des Lenkwinkelsignals ermittelt werden.

Der Rotorpositionssensor weist beispielsweise wenigstens einen Hall-Sensor auf. Der Rotorpositionssensor kann in einer anderen Ausführungsform wenigstens einen AMR-Sensor oder wenigstens einen GMR-Sensor aufweisen.

In einer bevorzugten Ausführungsform ist das Lenkwinkelsignal ein zeitkontinuierliches, insbesondere analoges Signal. Die Steuereinheit weist bevorzugt in dieser Ausführungsform einen Analog-Digital-Wandler auf, welcher mit dem Eingang für das Lenkwinkelsignal verbunden ist. Die Steuereinheit ist ausgebildet, ein Rotorpositionssignal aus dem Sensorsignal und dem Lenkwinkelsignal zu erzeugen, und den Stator in Abhängigkeit des erzeugten Rotorpositionssignals anzusteuern.

Der Analog-Digital-Wandler ist bevorzugt ausgebildet, das analoge Lenkwinkelsignal abzutasten, zu quantisieren und ein digitales Ausgangssignal zu erzeugen.

Die Erfindung betrifft auch eine Lenkvorrichtung mit einem Elektromotor der vorbeschriebenen Art. Die Lenkvorrichtung, im Folgenden auch Lenkanordnung genannt, weist den Lenkwinkelsensor auf, welcher ausgebildet ist, einen Lenkwinkel einer Fahrzeuglenkung zu erfassen und das Lenkwinkelsignal zu erzeugen. Das Lenkwinkelsignal repräsentiert einen Lenkwinkel einer Fahrzeuglenkung, insbesondere eines Fahrzeuglenkrades.

Weiter bevorzugt ist die Lenkvorrichtung auch zum Erzeugen eines ein Fahrzeuglenken unterstützenden Lenkmoments ausgebildet.

Die Erfindung betrifft auch ein Verfahren zum Betreiben einer Lenkvorrichtung für ein Kraftfahrzeug. Bei dem Verfahren wird mittels eines elektronisch kommutierten Elektromotors ein das Lenken unterstützendes Lenkmoment erzeugt. Bei dem Verfahren wird auch eine vorbestimmte Anzahl von insbesondere diskreten Rotorpositionen entlang einer Rotorumlaufrichtung eines Rotors des Elektromotors erfasst. Bei dem Verfahren wird auch ein die Rotorpositionen repräsentierendes Sensorsignal erzeugt, und ein magnetisches Drehfeld zum Erzeugen des unterstützenden Lenkmoments in Abhängigkeit des Sensorsignals erzeugt.

Erfindungsgemäß wird bei dem Verfahren ein einen Lenkwinkel der Lenkvorrichtung repräsentierendes, insbesondere analoges oder digitales Lenkwinkelsignal erzeugt, und das magnetische Drehfeld zum Erzeugen des unterstützenden Lenkmoments zusätzlich in Abhängigkeit des Lenkwinkelsignals erzeugt.

Unabhängig oder zusätzlich vom Erfindungsgedanken, eine Rotorpositionserfassung in Abhängigkeit eines Lenkwinkelsignals hinsichtlich Auflösung und/oder Erfassungswinkelbereich zu verbessern, kann ein Lenkwinkelsignal in Abhängigkeit eines Rotorpositionssignals hinsichtlich Auflösung und/oder Erfassungswinkelbereich verbessert werden.

Die Erfindung wird nun im Folgenden anhand von Figuren und weiteren Ausführungsbeispielen beschrieben. Weitere vorteilhafte Ausführungsvarianten der Erfindung ergeben sich aus den Merkmalen der abhängigen Ansprüche sowie aus den Merkmalen der Figurenbeschreibung.
Figur 1 zeigt ein Ausführungsbeispiel für eine Lenkanordnung für ein Kraftfahrzeug;
Figur 2 zeigt ein Ausführungsbeispiel für ein Verfahren zum Betreiben einer Lenkanordnung für ein Kraftfahrzeug;
Figur 3 zeigt ein Ausführungsbeispiel für ein Rotorpositionssignal, welches sowohl von einem Rotorpositionssensor erzeugte Sensorsignale als auch aus einem von einem Lenkwinkelsensor erzeugten Lenkwinkelsignal errechnete Rotorpositionssignale umfasst.

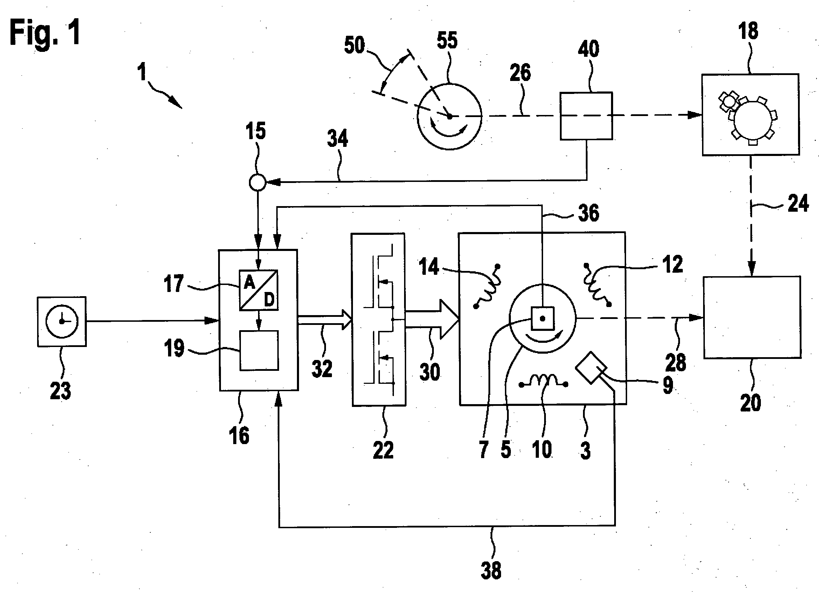

Figur 1 zeigt ein Ausführungsbeispiel für eine Lenkanordnung 1 für ein Kraftfahrzeug. Die Lenkanordnung 1 weist einen elektronisch kommutierten Elektromotor mit einem Stator 3 und einem Rotor 5 auf. Der Rotor 5 ist in diesem Ausführungsbeispiel permanentmagnetisch ausgebildet. Der Elektromotor weist auch einen Rotorpositionssensor 7 auf. Der Rotorpositionssensor 7 ist als AMR-Sensor ausgebildet. Zusätzlich oder alternativ zu dem Rotorpositionssensor 7 kann der Elektromotor einen Rotorpositionssensor 9 aufweisen, welcher in diesem Ausführungsbeispiel als Hall-Sensor ausgebildet ist.

Der Stator 3 des Elektromotors umfasst Statorspulen, in diesem Ausführungsbeispiel 3 Statorspulen 10, 12 und 14.

Die Lenkanordnung 1 weist auch eine Steuereinheit 16 auf, welche über eine Verbindung 32 mit einer Leistungsendstufe 22 verbunden ist. Die Leistungsendstufe 22 weist beispielsweise für jede der Statorspulen 10, 12 und 14 eine H-Brücke auf. Im Falle einer H-Brücke ist eine Statorspule mit einem Anschluss mit einem Ausgang einer Transistorhalbbrücke und mit einem anderen Anschluss mit einem Ausgang einer zweiten Transistorhalbbrücke verbunden.

In einer anderen Ausführungsform weist die Leistungsendstufe eine B6-Brücke auf. Im Falle einer B6-Brücke ist ein Ausgang einer Transistorhalbbrücke mit einem Anschluss einer Erregerspule verbunden, ein zweiter Anschluss der Erregerspule ist - je nach Schaltung der Erregerspulen - im Falle einer Sternschaltung mit den zweiten Anschlüssen der anderen Erregerspulen verbunden, im Falle einer Dreieckschaltung mit einem ersten Anschluss einer anderen Erregerspule verbunden.

Die Transistoren können beispielsweise jeweils als MOS-FET (MOS-FET = Metal-Oxide-Semiconductor-Field-Effect-Transistor), als MIS-FET (MIS = Metal-Insulator-Semiconductor), als bipolarer Transistor, als JFET (JFET = Junction-FET), als IGBT (IGBT = Insulated-Gate-Bipolar-Transistor), als HEMT ( HEMT = High-Electron-Mobility-Transistor), oder als HBT ( HBT = Heterojunction-BipolarTransistor) ausgebildet sein.

Die Leistungsendstufe 22 ist ausgangsseitig über eine Verbindung 30 mit dem Stator 3, und dort mit den Statorspulen 10, 12 und 14 verbunden. Die Leistungsendstufe 22 ist ausgebildet, in Abhängigkeit eines eingangsseitig über die Verbindung 32 empfangenen Steuersignals, die Statorspulen 10, 12 und 14 des Stators 3 zum Erzeugen eines magnetischen Drehfeldes zu bestromen. Die Steuereinheit 16 ist ausgebildet, die Steuersignale zum Erzeugen des magnetischen Drehfeldes zu erzeugen und die Leistungsendstufe 22 über die Verbindung 32 entsprechend anzusteuern. Die Steuereinheit 16 weist auch einen Analog-Digital-Wandler 17 auf. Der Analog-Digital-Wandler 17 ist ausgangsseitig mit einer Recheneinheit 19 der Steuereinheit 16 verbunden. Die Steuereinheit 16 weist auch einen Eingang 15 für ein Lenkwinkelsignal auf, welcher mit dem Analog-Digital-Wandler 17 verbunden ist. Die Lenkanordnung 1 weist auch einen Lenkwinkelsensor 40 auf, welcher mit einer Lenkwelle 26 wirkverbunden ist. Der Lenkwinkelsensor 40 ist ausgebildet, eine Drehung, insbesondere einen Winkel einer Drehung eines Lenkrades oder der Lenkwelle, insbesondere Lenksäule, zu erfassen und ein den Lenkwinkel repräsentierendes Lenkwinkelsignal zu erzeugen und dieses ausgangsseitig auszugeben. Der Lenkwinkelsensor 40 ist dazu ausgangsseitig über eine Verbindungsleitung 34 mit dem Eingang 15 der Steuereinheit 16 verbunden. Die Steuereinheit ist auch eingangsseitig mit einem Zeitgeber 23 verbunden. Der Zeitgeber 23 ist ausgebildet, ein Zeitsignal als Zeitbasis zum Errechnen von Rotorpositionen aus dem Lenkwinkelsignal zu erzeugen und dieses ausgangsseitig an die Steuereinheit 16 auszugeben. Der Zeitgeber 23 weist beispielsweise einen Schwingquarz auf.

Die Lenkanordnung 1 weist auch ein Lenkrad 55 auf, welches über die Lenkwelle 26 mit einem Lenkgetriebe 18 drehverbunden ist.

Das Lenkgetriebe 18 ist über eine Welle 24 mit einer Fahrzeuglenkung 20 verbunden. Die Fahrzeuglenkung 20 ist auch über eine Welle 28 mit dem Rotor 5 des Elektromotors drehverbunden.

Der Rotor 5 des Elektromotors ist ausgebildet, in Abhängigkeit von dem magnetischen Drehfeld ein Lenkmoment zum Lenken eines Fahrzeugs zu erzeugen, welches ein von dem Lenkrad 55 erzeugtes Lenkmoment wirksam unterstützen kann.

Dargestellt ist auch der Lenkwinkel 50, welcher von dem Lenkwinkelsensor 40 erfasst worden sein kann.

Die Wirkungsweise der Lenkanordnung 1 wird nun im Folgenden erläutert:
Wenn ein Benutzer des Fahrzeugs mittels des Lenkrads 55 ein Lenkmoment erzeugt, und dabei das Lenkrad 55 um den Lenkwinkel 50 dreht, kann der Lenkwinkelsensor 40 den Lenkwinkel 50 erfassen und ein insbesondere analoges, den Lenkwinkel repräsentierendes Lenkwinkelsignal erzeugen.

Die Steuereinheit 16 kann das am Eingang 15 empfangene Lenkwinkelsignal mittels des Analog-Digital-Wandlers 17 abtasten und quantisieren und das so abgetastete und quantisierte Lenkwinkelsignal ausgangsseitig an die Recheneinheit 19 ausgeben. Die Recheneinheit 19 ist ausgebildet, in Abhängigkeit des - von dem Zeitgeber 23 empfangenen Zeitsignals - das von dem Analog-Digital-Wandler 17 empfangene Lenkwinkelsignal entsprechend einem vorbestimmten Untersetzungsverhältnis in eine Rotorposition, insbesondere einen Rotorwinkel einer Drehung des Rotors 5 umrechnen.

Die Steuereinheit 16 ist auch über eine Verbindungsleitung 36 eingangsseitig mit einem Rotorpositionssensor 7 verbunden. Der Rotorpositionssensor 7 ist ausgebildet, wenigstens eine Rotorposition, in diesem Ausführungsbeispiel 2 Rotorpositionen des Rotors 5 zu erfassen und ein die Rotorposition des Rotors 5 repräsentierendes Sensorsignal ausgangsseitig auszugeben.

Der Rotorpositionssensor 7 ist beispielsweise ein AMR-Sensor oder ein GMR-Sensor. Beispielsweise ist der GMR-Sensor oder der AMR-Sensor ausgebildet, ein zeitkontinuierliches, analoges Rotorpositionssignal zu erzeugen und ist mit einem Analog-Digitalwandler verbunden. Eine Winkelauflösung des Rotorpositionssensors ist dann durch eine Abtastrate eines das analoge Rotorpositionssignal analog-zu-digital wandelnden Analog-Digital-Wandlers bestimmt. Im Falle eines Rotorpositionssensors in Form von wenigstens einem Hall-Sensor ist die Winkelauflösung durch die Zahl der Hall-Sensoren bestimmt.

Die Steuereinheit 16 ist ausgebildet, die Steuersignale zum Erzeugen des magnetischen Drehfeldes in Abhängigkeit des von dem Rotorpositionssensor 7 und/oder von dem Rotorpositionssensor 9 erzeugten Sensorsignals zu erzeugen.

Die Steuereinheit 16 ist ausgebildet, ein Rotorpositionssignal zum Erzeugen des magnetischen Drehfeldes zu erzeugen, welches sowohl das von dem Rotorpositionssensor 7 und/oder von dem Rotorpositionssensor 9 erfasste Rotorpositionen, als auch von der Recheneinheit 19 in Abhängigkeit des Lenkwinkelsignals gemäß dem Untersetzungsverhältnis errechnete Rotorpositionen umfasst.

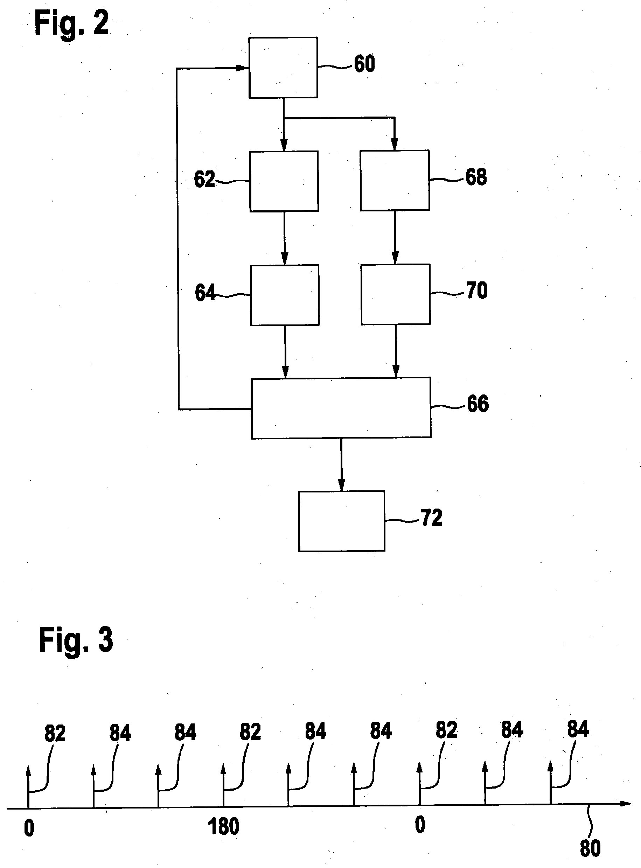

Figur 2 zeigt ein Ausführungsbeispiel für ein Verfahren zum Betreiben einer Lenkanordnung eines Kraftfahrzeugs, insbesondere der in Figur 1 dargestellten Lenkanordnung 1.

Bei dem Verfahren wird in einem Schritt 60 ein Zeitgeber gestartet - beispielsweise der in Figur 1 dargestellte Zeitgeber 23. In einem Schritt 62 werden - in Abhängigkeit von dem Schritt 60 als Zeitbasis - eine vorbestimmte Anzahl von insbesondere diskreten Rotorpositionen entlang einer Rotorumlaufrichtung eines Rotors des Elektromotors erfasst und in einem Schritt 64 ein die Rotorpositionen repräsentierendes Sensorsignal erzeugt. In einem Schritt 68 wird - in Abhängigkeit von dem Schritt 60 als Zeitbasis - ein Lenkwinkel einer Fahrzeuglenkung des Kraftfahrzeugs erfasst und ein den Lenkwinkel repräsentierendes Lenkwinkelsignal erzeugt. In einem Schritt 70 wird aus dem Lenkwinkelsignal gemäß einer vorbestimmten Zuordnungsvorschrift - insbesondere gemäß einem Untersetzungsverhältnis - ein Rotorpositionsänderung einer Rotorposition des Rotors ermittelt und ein die Rotorpositionsänderung repräsentierendes Signal erzeugt. In einem Schritt 66 wird aus dem im Schritt 64 erzeugten Rotorpositionssignal und dem im Schritt 70 erzeugten, die Rotorpositionsänderung repräsentierenden Signal ein Rotorpositionssignal erzeugt, das sowohl von dem Rotorpositionssensor erfasste Rotorpositionen als auch aus dem Lenkwinkelsignal errechnete Rotorpositionen aufweist.

In einem Schritt 72 wird das magnetische Drehfeld zum Erzeugen des unterstützenden Lenkmoments in Abhängigkeit des im Schritt 66 erzeugten Rotorpositionssignals erzeugt.

An den Schritt 66 kann - beispielsweise nach einem Rotorumlauf oder einer vorbestimmten Zahl von Rotorumläufen - der Zeitgeber im Schritt 60 erneut gestartet werden.

Figur 3 zeigt ein Ausführungsbeispiel für ein Rotorpositionssignal, welches die in Figur 1 dargestellte Steuereinheit zum Erzeugen des magnetischen Drehfeldes zum Unterstützen eines Fahrzeuglenkens erzeugt hat.

Dargestellt ist eine Zeitachse 80, auf der Rotorpositionen 82 aufgetragen sind. Die Rotorpositionen 82 sind von dem in Figur 1 dargestellten Rotorpositionssensor 7 und/oder dem Rotorpositionssensor 9 erfasst worden. Zusätzlich zu den Rotorpositionen 82 umfasst das Rotorpositionssignal Rotorpositionen 84, welche von der in Figur 1 dargestellten Recheneinheit in Abhängigkeit des Lenkwinkelsignals erzeugt worden sind. Sichtbar ist, dass eine Abtastrate der Rotorposition des in Figur 1 dargestellten Rotors 5 mittels des Lenkwinkelsignals, welches von der Steuereinheit 16 am Eingang 15 empfangen und von der Recheneinheit 19 in Abhängigkeit des Untersetzungsverhältnisses in weitere Rotorpositionen umgerechnet worden ist, höher ist als die Abtastrate, repräsentiert durch die Rotorpositionen 82 alleine.

## Patentansprüche

1. Elektronisch kommutierter Elektromotor (3, 5, 7, 9) mit einem Stator (3) und einem insbesondere permanentmagnetisch ausgebildeten Rotor (5), wobei der Elektromotor (3, 5, 7, 9) einen Rotorpositionssensor (7, 9) aufweist, welcher ausgebildet ist, eine vorbestimmte Anzahl von insbesondere diskreten Rotorpositionen (82) entlang einer Rotorumlaufrichtung (80) des Rotors (5) zu erfassen, und ein die Rotorpositionen (82) repräsentierendes Sensorsignal zu erzeugen, und mit einer mit dem Rotorpositionssensor (7, 9) verbundenen Steuereinheit (16), welche ausgebildet ist, den Stator zum Erzeugen eines magnetischen Drehfeldes in Abhängigkeit des Sensorsignals (82) anzusteuern,
**dadurch gekennzeichnet, dass**
die Steuereinheit (16) einen Eingang (15) für ein einen Lenkwinkel einer Fahrzeuglenkung repräsentierendes, insbesondere analoges oder digitales Lenkwinkelsignal aufweist und ausgebildet ist, den Stator (3) zusätzlich in Abhängigkeit des Lenkwinkelsignals (84) anzusteuern,
wobei die Steuereinheit (16) ausgebildet ist, wenigstens eine Rotorposition (84) des Rotors (5) in Abhängigkeit des Lenkwinkelsignals zu ermitteln, um einen Erfassungswinkelbereich einer Rotorpositionserfassung entlang eines Rotorumlaufes im Vergleich zu einem bloßen Ansteuern in Abhängigkeit des Sensorsignals des Rotorpositionssensors zu erhöhen.

2. Elektronisch kommutierter Elektromotor (3, 5, 7, 9) nach Anspruch 1,
**dadurch gekennzeichnet, dass**
die Steuereinheit zum Ermitteln des Rotorpositionssignals in Abhängigkeit des Lenkwinkelsignals wenigstens eine Recheneinheit und einen mit der Recheneinheit verbundenen Zeitgeber aufweist.

3. Elektronisch kommutierter Elektromotor (3, 5, 7, 9) nach einem der vorhergehenden Ansprüche,
**dadurch gekennzeichnet, dass**
die Steuereinheit (16, 19) ausgebildet ist, die wenigstens eine Rotorposition (84) gemäß einem vorbestimmten Untersetzungsverhältnis zu ermitteln.

4. Elektronisch kommutierter Elektromotor (3, 5, 7, 9) nach einem der vorhergehenden Ansprüche,
**dadurch gekennzeichnet, dass**

5. Elektronisch kommutierter Elektromotor (3, 5, 7, 9) nach einem der vorhergehenden Ansprüche,
**dadurch gekennzeichnet, dass**
der Rotorpositionssensor (7, 9) ausgebildet ist, bis zu vier Rotorpositionen entlang eines Rotorumlaufes (80) des Rotors (5) zu erfassen.

6. Elektronisch kommutierter Elektromotor (3, 5, 7, 9) nach einem der vorhergehenden Ansprüche,
**dadurch gekennzeichnet, dass**
der Rotorpositionssensor (9) wenigstens einen Hall-Sensor aufweist.

7. Elektronisch kommutierter Elektromotor (3, 5, 7, 9) nach einem der vorhergehenden Ansprüche 1 bis 4,
**dadurch gekennzeichnet, dass**
der Rotorpositionssensor (7) ein AMR-Sensor oder ein GMR-Sensor ist.

8. Elektronisch kommutierter Elektromotor (3, 5, 7, 9) nach einem der vorhergehenden Ansprüche,
**dadurch gekennzeichnet, dass**
das Lenkwinkelsignal ein zeitkontinuierliches, analoges Signal ist.

9. Elektronisch kommutierter Elektromotor (3, 5, 7, 9) nach einem der vorhergehenden Ansprüche,
**dadurch gekennzeichnet, dass**
die Steuereinheit (16) einen Analog-Digitalwandler (17) aufweist, welcher mit dem Eingang (15) für das Lenkwinkelsignal verbunden ist, wobei die Steuereinheit (16) ausgebildet ist, ein Rotorpositionssignal aus dem Sensorsignal (82) und dem Lenkwinkelsignal (84) zu erzeugen und den Stator in Abhängigkeit des erzeugten Rotorpositionssignals anzusteuern.

10. Lenkvorrichtung (1) mit einem Elektromotor (3, 5, 7, 9) nach einem der vorhergehenden Ansprüche,
**dadurch gekennzeichnet, dass**
die Lenkvorrichtung (1) einen Lenkwinkelsensor (40) aufweist, welcher ausgebildet ist, einen Lenkwinkel (50) einer Fahrzeuglenkung (55) zu erfassen und das Lenkwinkelsignal zu erzeugen.

11. Verfahren zum Betreiben einer Lenkvorrichtung für ein Kraftfahrzeug, bei dem mittels eines elektronisch kommutierten Elektromotors ein ein Lenken des Kraftfahrzeugs unterstützendes Lenkmoment erzeugt wird, und bei dem eine vorbestimmte Anzahl von insbesondere diskreten Rotorpositionen (82) entlang einer Rotorumlaufrichtung (82) eines Rotors (5) des Elektromotors (3, 5, 7, 9) erfasst wird, und ein die Rotorpositionen (82) repräsentierendes Sensorsignal erzeugt wird, und ein magnetischen Drehfeld zum Erzeugen des unterstützenden Lenkmoments in Abhängigkeit des Sensorsignals erzeugt wird,
**dadurch gekennzeichnet, dass**
ein einen Lenkwinkel einer Fahrzeuglenkung repräsentierendes, insbesondere analoges oder digitales Lenkwinkelsignal erzeugt wird und das magnetische Drehfeld zum Erzeugen des unterstützenden Lenkmoments zusätzlich in Abhängigkeit des Lenkwinkelsignals (84) erzeugt wird, wobei wenigstens eine Rotorposition (84) des Rotors (5) in Abhängigkeit des Lenkwinkelsignals ermittelt wird, um einen
Erfassungswinkelbereich einer Rotorpositionserfassung entlang eines Rotorumlaufes im Vergleich zu einem bloßen Ansteuern in Abhängigkeit des Sensorsignals des Rotorpositionssensors zu erhöhen.

## Claims

1. Electronically commutated electric motor (3, 5, 7, 9) comprising a stator (3) and a rotor (5) which is, in particular, of permanent magnetic design, wherein the electric motor (3, 5, 7, 9) has a rotor position sensor (7, 9) which is designed to sense a predetermined number of, in particular, discrete rotor positions (82) in a rotational direction (80) of the rotor (5) and to generate a sensor signal which represents the rotor positions (82), and comprising a control unit (16) which is connected to the rotor position sensor (7, 9) and is designed to actuate the stator in order to generate a magnetic induction field as a function of the sensor signal (82),
**characterized in that**
the control unit (16) has an input (15) for a steering angle signal, in particular an analog or digital steering angle signal, which represents a steering angle of a vehicle steering system, which control unit (16) is designed to actuate the stator (3) additionally as a function of the steering angle signal (84) wherein the control unit (16) is designed to determine at least one rotor position (84) of the rotor (5) as a function of the steering angle signal, in order to increase a sensing angle range of a rotor-positon-sensing means along a rotor circumference compared to actuation alone as a function of the sensor signal of the rotor position sensor.

2. Electronically commutated electric (3, 5, 7, 9) motor according to claim 1,
**characterized in that**
the control unit for determining the rotor position signal as a function of the steering angle has at least one computing unit and a timer connected to the computing unit.

3. Electronically commutated electric (3, 5, 7, 9) motor according to one of the preceding claims,
**characterized in that**
the control unit (16, 19) is designed to determine the at least one rotor position (84) according to a predetermined step-down ratio.

4. Electronically commutated electric (3, 5, 7, 9) motor according to one of the preceding claims,
**characterized in that**

5. Electronically commutated electric (3, 5, 7, 9) motor according to one of the preceding claims,
**characterized in that**
the rotor position sensor (7, 9) is designed to sense up to four rotor positions along a rotor circumference (80) of the rotor (5).

6. Electronically commutated electric (3, 5, 7, 9) motor according to one of the preceding claims,
**characterized in that**
the rotor position sensor (9) has at least one Hall sensor.

7. Electronically commutated electric (3, 5, 7, 9) motor according to one of the preceding claims 1 to 4,
**characterized in that**
the rotor position sensor (7) is an AMR sensor or a GMR sensor.

8. Electronically commutated electric (3, 5, 7, 9) motor according to one of the preceding claims,
**characterized in that**
the steering angle signal is an analog signal which is continuous over time.

9. Electronically commutated electric (3, 5, 7, 9) motor according to one of the preceding claims,
**characterized in that**
the control unit (16) has an analog/digital converter (17) which is connected to the input (15) for the steering angle signal, wherein the control unit (16) is designed to generate a rotor position signal from the sensor signal (82) and the steering angle signal (84) and to actuate the stator as a function of the generated rotor position signal.

10. Steering device (1) having an electric motor (3, 5, 7, 9) according to one of the preceding claims,
**characterized in that**
the steering device (1) has a steering angle sensor (40) which is designed to sense a steering angle (50) of a vehicle steering system (55) and to generate the steering angle signal.

11. Method for operating a steering device for a motor vehicle, in which a steering torque which assists steering of the motor vehicle is generated by means of an electronically commutated electric motor and in which a predetermined number of, in particular, discrete rotor positions (82) is sensed in a rotational direction (82) of a rotor (5) of the electric motor (3, 5, 7, 9), and a sensor signal which represents the rotor positions (82) is generated, and a magnetic induction field for generating the assisting steering torque is generated as a function of the sensor signal,
**characterized in that**
an, in particular, analog or digital steering angle signal which represents a steering angle of a vehicle steering system is generated and the magnetic induction field for generating the assisting steering torque is additionally generated as a function of the steering angle signal (84) wherein at least one rotor position (84) of the rotor (5) is determined as a function of the steering angle signal, in order to increase a sensing angle range of a rotorposition-sensing means along a rotor circumference compared to actuation alone as a function of the sensor signal of the rotor position sensor.

## Revendications

1. Moteur électrique commuté électroniquement (3, 5, 7, 9) comportant un stator (3) et un rotor (5) notamment réalisé de manière à ce qu'il soit du type à magnétisation permanente, dans lequel le moteur électrique (3, 5, 7, 9) comprend un capteur de position de rotor (7, 9) qui est réalisé de manière à acquérir un nombre prédéterminé de positions de rotor (82), notamment discrètes, le long d'une direction de rotation de rotor (80) du rotor (5), et à générer un signal de capteur représentant les positions de rotor (82), et comportant une unité de commande (16) reliée au capteur de position de rotor (7, 9), qui est réalisée de manière à commander le stator afin qu'il génère un champ magnétique tournant en fonction du signal de capteur (82),
**caractérisé en ce que** l'unité de commande (16) comprend une entrée (15) pour un signal d'angle de braquage, notamment analogique ou numérique, représentant un angle de braquage d'une direction de véhicule et est réalisée de manière à commander en outre le stator (3) en fonction du signal d'angle de braquage (84),
dans lequel l'unité de commande (16) est réalisée de manière à déterminer au moins une position de rotor (84) du rotor (5) en fonction du signal d'angle de braquage, afin d'augmenter une région angulaire d'acquisition d'une acquisition de position de rotor le long d'un tour du rotor par comparaison à une commande simple en fonction du signal de capteur du capteur de position de rotor.

2. Moteur électrique commuté électroniquement (3, 5, 7, 9) selon la revendication 1,
**caractérisé en ce que** l'unité de commande comprend au moins une unité de calcul et un temporisateur relié à l'unité de calcul pour déterminer le signal de position de rotor en fonction du signal d'angle de braquage.

3. Moteur électrique commuté électroniquement (3, 5, 7, 9) selon l'une quelconque des revendications précédentes,
**caractérisé en ce que** l'unité de commande (16, 19) est réalisée de manière à déterminer l'au moins une position de rotor (84) conformément à un rapport de réduction prédéterminé.

4. Moteur électrique commuté électroniquement (3, 5, 7, 9) selon l'une quelconque des revendications précédentes,
**caractérisé en ce que**

5. Moteur électrique commuté électroniquement (3, 5, 7, 9) selon l'une quelconque des revendications précédentes,
**caractérisé en ce que** le capteur de position de rotor (7, 9) est réalisé de manière à acquérir jusqu'à quatre positions de rotor le long d'un tour de rotor (80) du rotor (5).

6. Moteur électrique commuté électroniquement (3, 5, 7, 9) selon l'une quelconque des revendications précédentes,
**caractérisé en ce que** le capteur de position de rotor (9) comprend au moins un capteur à effet Hall.

7. Moteur électrique commuté électroniquement (3, 5, 7, 9) selon l'une quelconque des revendications précédentes, 1 à 4,
**caractérisé en ce que** le capteur de position de rotor (7) est un capteur AMR ou un capteur GMR.

8. Moteur électrique commuté électroniquement (3, 5, 7, 9) selon l'une quelconque des revendications précédentes,
**caractérisé en ce que** le signal d'angle de braquage est un signal analogique continu dans le temps.

9. Moteur électrique commuté électroniquement (3, 5, 7, 9) selon l'une quelconque des revendications précédentes,
**caractérisé en ce que** l'unité de commande (16) comprend un convertisseur analogique-numérique (17) qui est relié à l'entrée (15) destinée au signal d'angle de braquage, dans lequel l'unité de commande (16) est réalisée de manière à générer un signal de position de rotor à partir du signal de capteur (82) et du signal d'angle de braquage (84) et de manière à commander le stator en fonction du signal de position de rotor généré.

10. Dispositif de direction (1) comportant un moteur électrique (3, 5, 7, 9) selon l'une quelconque des revendications précédentes,
**caractérisé en ce que** le dispositif de direction (1) comprend un capteur d'angle de braquage (40) qui est réalisé de manière à acquérir un angle de braquage (50) d'une direction de véhicule (55) et à générer le signal d'angle de braquage.

11. Procédé de mise en fonctionnement un dispositif de direction pour un véhicule automobile, dans lequel un couple de braquage d'assistance au braquage du véhicule automobile est généré au moyen d'un moteur électrique commuté électroniquement, et dans lequel un nombre prédéterminé de positions de rotor (82), notamment discrètes, le long d'une direction de rotation de rotor (82) d'un rotor (5) du moteur électrique (3, 5, 7, 9) est acquis, un signal de capteur représentant les positions de rotor (82) est généré, et un champ magnétique tournant destiné à générer le couple de braquage d'assistance est généré en fonction du signal de capteur,
**caractérisé en ce qu'**un signal d'angle de braquage, notamment analogique ou numérique, représentant un angle de braquage d'une direction de véhicule est généré et **en ce que** le champ magnétique tournant est en outre généré pour générer le couple de braquage d'assistance en fonction du signal d'angle de braquage (84), dans lequel au moins une position de rotor (84) du rotor (5) est déterminée en fonction du signal d'angle de braquage, afin d'augmenter une région angulaire d'acquisition d'une acquisition de position de rotor le long d'un tour de rotor par comparaison à une commande simple en fonction du signal de capteur du capteur de position de rotor.
